Europäisches Patentamt

European Patent Office

Office européen des brevets

(19)

(11) EP 0 849 809 A1

(12) **DEMANDE DE BREVET EUROPEEN**

(43) Date de publication:
24.06.1998 Bulletin 1998/26

(51) Int Cl.6: **H01L 31/0236**, H01L 31/0352

(21) Numéro de dépôt: 97403090.0

(22) Date de dépôt: 19.12.1997

(84) Etats contractants désignés:
AT BE CH DE DK ES FI FR GB GR IE IT LI LU MC
NL PT SE
Etats d'extension désignés:
AL LT LV MK RO SI

(30) Priorité: 20.12.1996 FR 9615738

(71) Demandeur: THOMSON-CSF
75008 Paris (FR)

(72) Inventeurs:
• Rosencher, Emmanuel
  94117 Arcueil Cedex (FR)
• Vinter, Borge
  94117 Arcueil Cedex (FR)
• Berger, Vincant
  94117 Arcueil Cedex (FR)
• Kaplan, Daniel
  94117 Arcueil Cedex (FR)
• Micheron, François
  94117 Arcueil Cedex (FR)

(54) **Détecteur infrarouge à structure quantique, non refroidie**

(57) L'invention concerne un détecteur, à structure quantique comportant un matériau semiconducteur à petit gap inséré entre deux matériaux semiconducteurs à grand gap, la structure comprenant un réseau de couplage entre l'onde à détecter et la zone détectrice constituée par le matériau à petit gap. Dans ces conditions, la zone détectrice peut être de très faible épaisseur (typiquement de l'ordre de 1 000 Å) et conduire à une détectivité limitée par le courant d'obscurité, élevée.

Application: Détection infrarouge.

FIG.3

EP 0 849 809 A1

## Description

Le domaine de l'invention est celui des détecteurs à structures à puits quantiques, fonctionnant dans l'infrarouge, aussi bien dans la bande II (entre 3 et 5 μm) que dans la bande III (entre 8 et 12 μm).

Actuellement trois types de détecteurs sont utilisés dans le domaine de l'infrarouge.

Un premier type concerne les détecteurs à jonction Schottky silicium/silicium de platine (Si/PtSi). Ces détecteurs conduisent à de bonnes performances (mesurées par une température minimale détectable appelée couramment NETD, de l'ordre de 80 mK dans la bande II pour des fréquences de lecture de 50 Hz, des surfaces de 50 μm x 50 μm et une ouverture optique de f/2), mais à de très faibles températures de fonctionnement (de l'ordre de 77 K).

Un deuxième type concerne les détecteurs thermiques bolométriques ou pyrométriques fondés sur le changement de propriétés électriques comme l'indice diélectrique ou la résistance sous l'effet de l'échauffement dû au rayonnement absorbé. Ces détecteurs conduisent à des performances plus modestes (NETD de l'ordre de 120 mK dans les conditions de mesure précédemment citées et pour la bande III). Néanmoins, ils présentent le grand intérêt de fonctionner à température ambiante, sans avoir besoin d'être refroidis.

Un troisième type de détecteurs est relatif aux détecteurs quantiques utilisant des jonctions p-n à base de semiconducteurs comme InSb, HgCdTe ou PbSnSe ou des transitions intersousbandes dans les puits quantiques de matériaux comme GaAs/AlGaAs.

Ces détecteurs présentent de très grandes performances (NETD voisine de 20 mK), mais fonctionnent à des températures de l'ordre de 200 K dans le meilleur des cas.

Ces derniers détecteurs très performants nécessitent donc un refroidissement cryogénique, représentant un surcoût de l'équipement.

En effet, comme décrit dans le livre "Optical and Infrared Detectors" édité par R.J. Keyes chez Springer-Verlag, la détectivité d'un composant de ce type est proportionnel à $I/\sqrt{I_{obsc}}$ où $I_{obsc}$ est le courant d'obscurité du détecteur. Dans les détecteurs quantiques à semiconducteur, le courant $I_{obsc}$ est thermiquement activé, c'est-à-dire qu'il varie en fonction de la température sous la forme $I_{obsc} \propto e^{-Eg/kT}$

où Eg est la largeur de la bande interdite encore appelée gap du semiconducteur, proche de l'énergie du photon à détecter.

Plus précisément, le courant d'obscurité dans un détecteur photovoltaïque est donné par l'équation suivante :

$$I_{obsc} = I_{diff} + I_{ZCE}$$

avec

$$I_{diff} = q \, L_{diff} \cdot n_i^2/\tau_{min} \cdot N_{dop}$$

et

$$I_{ZCE} = q \, n_i \, d/\tau_{min}$$

où

$I_{diff}$ est le courant de diffusion
$I_{ZCE}$ est le courant de zone de charge d'espace
$L_{diff}$ est la longueur de diffusion (typiquement de quelques dizaines à quelques centaines de microns).
$\tau_{min}$ est la durée de vie des porteurs minoritaires
$n_i$ est la densité intrinsèque de porteur
d est l'épaisseur de la zone de charge d'espace.

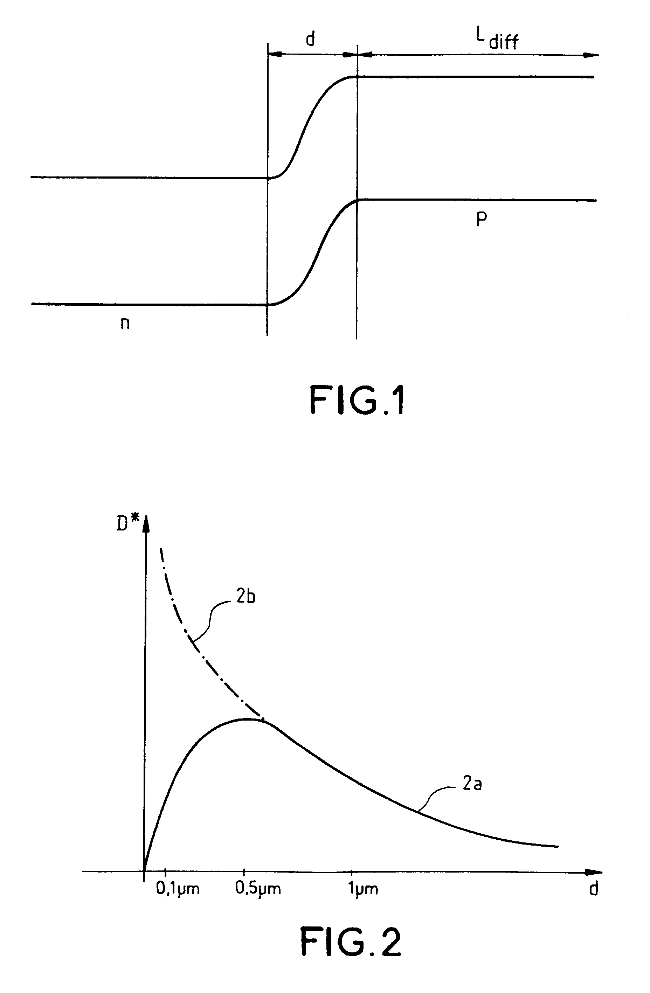

La figure 1 illustre un détecteur photovoltaïque classique présentant une jonction p-n, dans lequel sont représentées les longueurs $L_{diff}$ et d.

Dans ces détecteurs, c'est notamment $n_i^2$ qui fournit le terme thermiquement activé. De manière classique, en refroidissant ces détecteurs infrarouge, on diminue le courant d'obscurité et donc le bruit associé. Par ailleurs, le courant d'obscurité étant proportionnel à l'épaisseur d de la zone détectrice, on a intérêt à avoir une zone détectrice de très faible épaisseur. Plus précisément, la détectivité limitée par le courant d'obscurité est donnée par la formule :

$$D^* = \eta\lambda / \left[ u^{1/2} hc. \left(I_{obsc} / qG^2A\right)^{1/2} \right]$$

où

q est la charge de l'électron
h est la constante de Planck
c est la vitesse de la lumière
k est la constante de Boltzmann
T est la température
G est le gain de photoconduction (G = 1 si le composant est photovoltaïque)
u = 2 si le composant est photovoltaïque
u = 4 si le composant est photoconducteur
et $\eta$ est le rendement quantique donné par l'absorption de la lumière dans la couche d'épaisseur d soit :

$$\eta = 1 - e^{-\alpha d}$$

où
$\alpha$ est le coefficient d'absorption du matériau.

La détectivité $D^*$ est donc proportionnelle à :

$$D^* \alpha \, \eta(d)/ \sqrt{d}$$

et dans le cas classique η (d) = 1-e$^{-\alpha d}$

La figure 2 illustre l'évolution de la détectivité D* en fonction de l'épaisseur d. La courbe 2a est relative aux détecteurs quantiques classiques dans lesquels η (d) = 1-e$^{-\alpha d}$ et utilisant typiquement des épaisseurs voisines du micron. La courbe 2b est relative à un détecteur quantique dans lequel η (d) est constant. Avec ce type de détecteur, il devient particulièrement intéressant de fonctionner avec une très faible épaisseur d pouvant être de l'ordre de 0,1 μm et un rendement η quantique constant, la très faible épaisseur d conduisant à de faibles courants d'obscurité ne nécessitant plus un dispositif de refroidissement du détecteur.

Pour réaliser les conditions de fonctionnement exposés ci-dessus, le détecteur à structure quantique objet de l'invention est un détecteur comprenant un empilement de couches en matériaux semiconducteurs, sur un substrat, avec une zone détectrice de l'onde électromagnétique, caractérisé en ce que l'empilement de couches comporte une couche en matériaux semiconducteurs à faible énergie de bande interdite constituant la zone détectrice, comprise entre deux couches en matériau semiconducteur à grande énergie de bande interdite et qu'il comprend un réseau de couplage sur l'empilement de couches pour assurer un bon couplage entre l'onde optique à détecter et la zone détectrice.

Avantageusement, la couche de matériau semiconducteur à petit gap présente une faible épaisseur d, typiquement de l'ordre de 1 000 Å pour maintenir de faibles courants d'obscurité dans le détecteur.

Le réseau de couplage permet quant à lui d'augmenter le couplage entre la zone détectrice et l'onde électromagnétique afin de garder un rendement quantique η élevé.

Selon une première variante de l'invention, le détecteur quantique est un détecteur photoconducteur comprenant des moyens électriques pour mesurer des variations de résistivité dues à l'apport d'électrons dans la bande de conduction du matériau à petit gap, lors de la détection de l'onde optique. La région constituée de matériaux semiconducteurs à petit gap de faible épaisseur d est dans ce cas insérée entre deux couches constituées de matériaux semiconducteurs à grand gap SGC1 et SGC2 non dopés et donc idéalement isolants à température ambiante. Un réseau de diffraction peut avantageusement être gravé sur la couche supérieure de matériau semiconducteur SGC2; le pas Λ du réseau est tel qu'il y a une résonance entre la longueur d'onde de l'onde à détecter λ dans le matériau (si n est l'indice optique du matériau et λo la longueur d'onde de l'onde électromagnétique à détecter, dans le vide avec λ = λo/n) et le réseau, c'est-à-dire Λ = λo/n.

Selon une seconde variante de l'invention, le détecteur de l'invention est un détecteur photovoltaïque, la zone détectrice constituée de matériaux semiconducteurs à petit gap est insérée entre deux couches de matériaux semiconducteurs à grand gap dopés p et dopés n. Dans ce cas, les paires électron-trou créées par l'absorption des photons d'énergie de l'onde électromagnétique sont séparées par le champ électrique qui règne dans la jonction p-n. Les trous et/ou les électrons peuvent être drainés vers les extrémités et développer une différence de potentiel proportionnelle au flux de photons détectés, ladite différence de potentiel étant mesurée par des moyens électriques situés de part et d'autre de l'empilement des couches.

Avantageusement, le détecteur de l'invention peut comprendre deux couches barrières de matériaux semiconducteurs à très grand gap STG$_1$ et STG$_2$ situés aux interfaces des couches de matériaux SGG1/STG et SGG2/SPG pour éviter que cesdits interfaces ne se comportent comme des contacts ohmiques.

Avantageusement, le réseau de couplage est gravé dans la couche de matériau semiconducteur SGG2.

Avantageusement, le détecteur selon l'invention peut comprendre une couche de matériau semiconducteur SG comprise entre le substrat et l'empilement de couches de matériaux semiconducteurs SGG1/SPG/SGG2, le matériau SG ayant un indice de réfraction plus petit que celui du substrat S pour confiner l'onde dans l'empilement de couches.

L'invention sera mieux comprise et d'autres avantages apparaîtront à la lecture de la description qui va suivre, donnée à titre non limitatif et grâce aux figures annexées parmi lesquelles :

- la figure 1 schématise les longueurs de détection et de diffusion dans un détecteur selon l'art connu ;
- la figure 2 illustre l'évolution de la détectivité limitée par le courant d'obscurité, en fonction de l'épaisseur de la zone détectrice dans un détecteur quantique, à semiconducteur. La courbe 2a est relative à un détecteur quantique de l'art connu. La courbe 2b est relative à un détecteur quantique selon l'invention ;
- la figure 3 illustre un premier exemple de détecteur photoconducteur selon l'invention ;
- la figure 4 illustre un second exemple de détecteur photoconducteur selon l'invention ;
- la figure 5 illustre un premier exemple de détecteur photovoltaïque selon l'invention ;
- la figure 6 schématise les niveaux d'énergie définissant les bandes de valence et les bandes de conduction de l'ensemble des matériaux semiconducteurs utilisés dans un exemple de détecteur photoconducteur selon l'invention ;
- la figure 7 schématise les niveaux d'énergie définissant les bandes de valence et les bandes de conduction de l'ensemble des matériaux semiconducteurs utilisés dans un exemple de détecteur photovoltaïque selon l'invention, à hétérostructure de type III ;
- la figure 8 schématise les niveaux d'énergie définissant les bandes de valence et les bandes de conduction de l'ensemble des matériaux semiconducteurs utilisés dans un exemple de détecteur photovoltaïque à hétérostructure de type II ;

- la figure 9 schématise les niveaux d'énergie définissant les bandes de valence et les bandes de conduction de l'ensemble des matériaux semiconducteurs utilisés dans un exemple de détecteur photovoltaïque de type I.

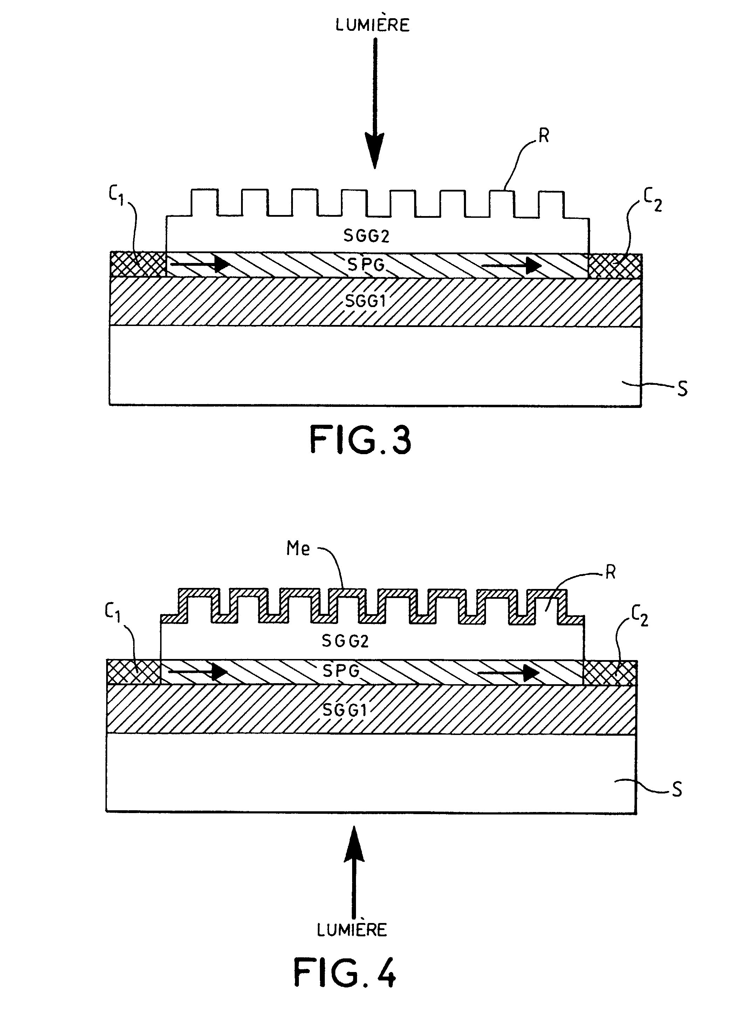

Selon une variante de l'invention, le détecteur à structure quantique fonctionnant dans l'infrarouge, fonctionne en photoconducteur, comme illustré en figure 3. Un substrat S supporte un empilement de couches constitutives du détecteur. Plus précisément, cet empilement de couches comprend :

- une couche de matériau semiconducteur non dopé, à grand gap $SGG_1$ ;
- une couche de matériau semiconducteur non dopé, à petit gap SPG ;
- une couche de matériau semiconducteur non dopé à grand gap $SGG_2$, dont la surface présente un réseau en relief, $R_1$ pour assurer un bon couplage entre l'onde électromagnétique à détecter et la zone détectrice constituée dans le cas présent par la couche de matériau SPG.

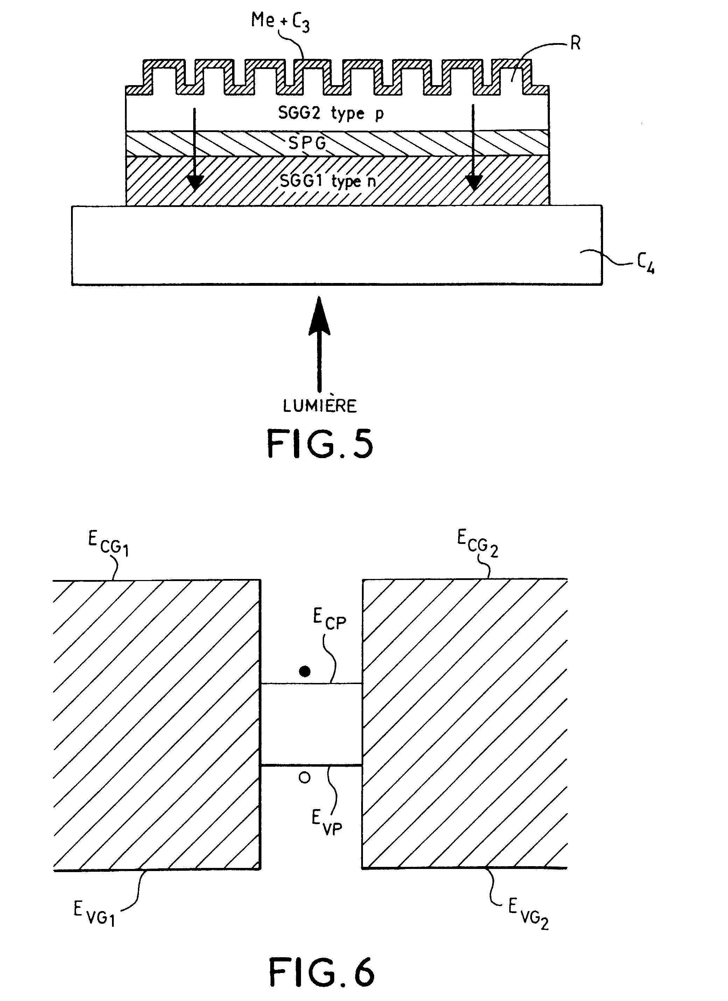

Ces paires électron-trou restent confinées dans la zone détectrice comme illustré en figure 6 qui représente un exemple de diagramme d'énergie de matériaux semiconducteurs SGG1, SPG et SGG2. L'énergie $E_{VP}$ est supérieure aux énergies $E_{VG1}$ et $E_{VG2}$ alors que l'énergie $E_{CP}$ est inférieure aux énergies $E_{CG1}$ et $E_{CG2}$.

Des contacts ohmiques $C_1$ et $C_2$ sont pris au niveau de la zone détectrice, de manière à mesurer les variations de résistance de ladite zone détectrice lors de l'apparition de paires électron-trou dues aux photons incidents.

La figure 3 illustre un détecteur dans lequel le réseau est transparent à la lumière incidente. La figure 4 décrit une autre variante de l'invention dans laquelle le réseau supporte une couche métallique Me, la lumière traversant le substrat.

Avantageusement, ce type de détecteur peut comprendre une couche guidante incluse dans la partie SGGI pour augmenter l'interaction entre l'onde et la partie SGP.

Selon une autre variante de l'invention, le détecteur fonctionne en détecteur photovoltaïque. Comme illustré en figure 5, il peut avantageusement comprendre :

- un substrat constitué d'un matériau semiconducteur dopé n, Sn ;
- une couche de matériau semiconducteur dopé de type n, à grand gap SGG1 ;
- une couche de matériau semiconducteur non dopé à petit gap SPG ;

- une couche de matériau semiconducteur dopé de type p, à grand gap SGGI, dont la surface présente un réseau en relief pour assurer un bon couplage entre l'onde à détecter et la zone détectrice constituée par la couche de matériau SPG.

Dans cette configuration, les déplacements des porteurs libres s'effectuent perpendiculairement au plan des couches et des contacts ohmiques $C_3$ et $C_4$ sont assurés de part et d'autre de l'empilement des couches. Le contact ohmique $C_3$ peut typiquement être réalisé par métallisation du réseau de couplage et prise de contact au niveau de la métallisation (Me + C3).

Pour assurer le transport des porteurs libres créés dans l'empilement des couches précitées, plusieurs alternatives peuvent être envisagées.

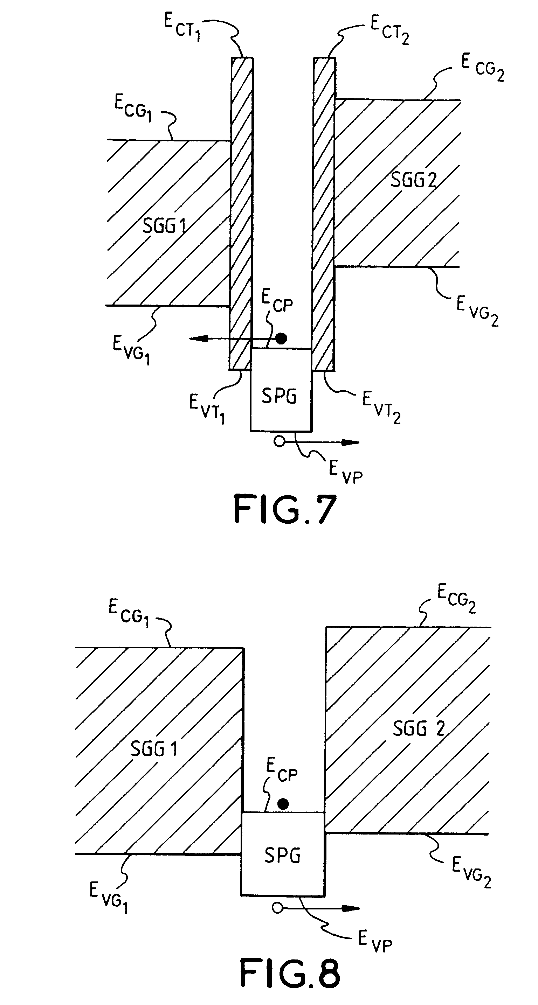

Dans une première variante de détecteur photoconducteur, on utilise une hétérostructure connue sous le nom de "type III" dans la littérature (C. Weisbuch et B. Vinter "Quantum Semiconductor Structures" Academic Press) dans laquelle le bas de la bande de la bande de conduction du semiconducteur à petit gap se situe sous le haut de la bande de valence des semiconducteurs à grand gap. La figure 7 schématise les bandes interdites des différents matériaux semiconducteurs utilisés dans ce type d'hétérostructure. Les photons incidents créent des paires électron-trou de part et d'autre de la bande interdite du matériau à petit gap SPG, cette bande interdite étant définie par l'énergie maximale de la bande de valence $E_{VP}$ et l'énergie minimale de la bande de conduction $E_{CP}$. Deux couches barrières constituées de matériaux à très grand gap doivent être interposées entre les couches de matériaux $SGG_{1n}$/SPG et SPG/$SGG_{2P}$. Ces matériaux à très grand gap ont des bandes interdites définies par les niveaux d'énergie $E_{VT1}$ et $E_{CT1}$ d'une part et $E_{VT2}$ et $E_{CT2}$ d'autre part, $E_{VT1}$ et $E_{VT2}$ sont inférieures à $E_{CP}$, $E_{CT1}$ et $E_{CT2}$ pouvant être supérieures à $E_{CG1}$ et $E_{CG2}$. Dans cette configuration, les niveaux d'énergie des matériaux à grand gap sont tels que le niveau $E_{VG1}$ est inférieur au niveau $E_{VG2}$, le niveau $E_{CG1}$ étant également inférieur au niveau $E_{CG2}$ puisque le matériau $SGG_1$ est dopé n alors que matériau $SGG_2$ est dopé p.

Selon une autre variante de détecteur photodétecteur, on utilise une hétérostructure de type II, dont le diagramme en énergie est illustré en figure 8. Dans ce type d'hétérostructure, un des types de porteurs (les électrons dans l'exemple de la figure 8) reste bloqué à l'intérieur du matériau à petit gap SPG, et peut donner lieu à un effet photovoltaïque interne.

Dans l'hétérostructure de la figure 8, le niveau d'énergie $E_{CP}$ est supérieur aux deux niveaux d'énergie $E_{VG1}$ et $E_{VG2}$, les électrons restent confinés dans la bande de conduction du matériau à petit gap SPG.

Les trous peuvent circuler vers le matériau semiconducteur dopé p, le matériau $SGG_2$ et ainsi générer un effet photovoltaïque interne.

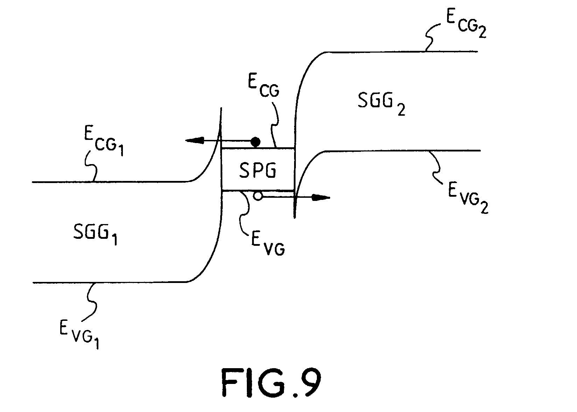

Selon une troisième variante de détecteur photoconducteur, on peut utiliser une hétérostructure de type 1, dont le diagramme d'énergie est représenté en figure 9. Les matériaux semiconducteurs à grand gap sont très fortement dopés et les niveaux maximum d'énergie des bandes de valence sont tels que $E_{VG1} < E_{VG} < E_{VG2}$.

Les niveaux minimum d'énergie des bandes de conduction étant tels que :

$$E_{CG1} < E_{CG} < E_{CG2}$$

Les paires électron-trou créées peuvent ainsi être émises par effet tunnel au travers de la zone dopée.

De manière générale, toutes les couches constitutives des détecteurs selon l'invention, peuvent être réalisées par toute technique connue de l'homme du métier. Néanmoins, afin d'éliminer les défauts électriques qui sont source de bruit, la structure $SGG_1/SPG/SGG_2$ doit être cristalline et donc obtenue par des techniques d'épitaxie par jet moléculaire ou par dépôt en phase vapeur. Les systèmes semiconducteurs possibles sont par exemple GaAlSb/InAsSb/GaAlSb, CdTe/HgCdTe/CdTe, PbS/PbSnSe/PbS, ...

### Exemple de réalisation d'un détecteur photoconducteur

Les matériaux semiconducteurs sont les suivants :

$SGG_1$ : GaSb
SPG : InAsSb
$SGG_2$ : AlSb

L'empilement de ces couches est réalisé en accord de maille, c'est-à-dire aux conditions où les distances entre atomes sont presque égales dans tous les matériaux. L'épitaxie suivante est réalisée :

A partir d'un substrat de GaSb, on épitaxie une couche de l'ordre de 0,2 µm de GaSb.

Sur cette couche de matériau $SGG_1$, on réalise une couche de 100 Å de $AlAs_{0,08}Sb_{0,92}$ qui est en accord de maille avec la couche de GaSb et forme une barrière pour les électrons créés dans InAsSb. Puis on réalise une couche détectrice de $InAs_{0,85}Sb_{0,15}$ de 0,1 µm puis de nouveau 100 Å de $AlAs_{0,08}Sb_{0,92}$ et enfin 0,6 µm de GaSb.

La composition de la couche InAsSb, est choisie pour obtenir une longueur d'onde de coupure (soit $InAs_{0,85}Sb_{0,15}$) de 5,1 µm.

Un réseau est gravé pour obtenir une résonance vers 5 µm, soit pour une période de réseau de 1,52 µm. La profondeur du réseau est de 0,3 µm.

Avec ces données, le rendement quantique maximal est de 80 % malgré une épaisseur très faible de 0,1 µm de la zone détectrice.

Sans réseau de couplage, une couche de 1 µm est nécessaire pour obtenir un rendement quantique identique conduisant à une température de bruit équivalente NETD de 150 mK. En abaissant à 0,1 µm l'épaisseur de la couche détectrice, on a augmenté la détectivité d'un facteur 3, ce qui conduit à une NETD de 50 mK.

### Exemple de réalisation d'un détecteur photovoltaïque

Le détecteur photovoltaïque est défini sur un substrat de GaSb dopé de type n.

Une couche de 1 µm de GaSb dopée de type n est épitaxiée sur ce substrat. Puis une couche d'environ 50 Å de $AlAs_{0,08}Sb_{0,92}$ est utilisée pour éviter que l'hétérostructure InAsSb/GaSn ne se comporte comme un contact ohmique. Une couche détectrice de $InAs_{0,85}Sb_{0,15}$ de 0,1 µm d'épaisseur est épitaxiée, puis 50 Å de $AlAs_{0,08}Sb_{0,92}$ et 1 µm de GaSb dopé de type p. Cette hétérostructure est de type III et permet aux électrons et aux trous d'être émis hors de la zone détectrice. Un réseau identique à celui de l'exemple de détecteur photoconducteur précédemment décrit, est gravé sur la couche GaSb dopée de type p. Puis une couche de métal (de l'or par exemple) est évaporée sur le réseau comme couche de contact électrique. L'amélioration des performances de ce détecteur photovoltaïque vis-à-vis d'un détecteur photovoltaïque de l'art antérieur est la même que celle mentionnée dans le cas de détecteurs photoconducteurs.

### Revendications

1.  Détecteur à structure quantique, d'onde optique comprenant un empilement de couches de matériaux semiconducteurs sur un substrat (S) avec une zone détectrice de l'onde électromagnétique, caractérisé en ce que l'empilement de couches comporte une couche en matériau semiconducteur (SPG) à faible énergie de bande interdite constituant la zone détectrice, comprise entre deux couches en matériaux semiconducteurs (SGG1) et (SGG2) à grande énergie de bande interdite et qu'il comprend un réseau de couplage sur l'empilement de couches pour assurer un bon couplage entre l'onde optique à détecter et la zone détectrice.

2.  Détecteur à structure quantique selon la revendication 1, caractérisé en ce que l'épaisseur de la zone détectrice est de l'ordre de 1 000 Å.

3.  Détecteur à structure quantique selon l'une des revendications 1 ou 2, caractérisé en ce qu'il comprend deux matériaux semiconducteurs (SGG1) et (SGG2) isolants et des moyens de mesure de variations de résistivité de la couche de matériau semiconducteur (SPG).

4.  Détecteur à structure quantique selon l'une des revendications 1 ou 2, caractérisé en ce qu'il comprend un matériau semiconducteur (SGG1) dopé de type n, un matériau semiconducteur (SGG2) dopé de type p et des moyens de mesure de tension situés de part et d'autre de l'empilement des couches.

5. Détecteur à structure quantique selon l'une des revendications 1 à 4, caractérisé en ce qu'il comprend deux couches barrières de matériaux semiconducteurs à très grand gap (STG1) et (STG2) situés aux interfaces des couches de matériaux (SGG1)/(SPG) et (SGG2)/(SPG).

6. Détecteur à structure quantique selon l'une des revendications 1 à 5, caractérisé en ce que le réseau de couplage est gravé dans la couche de matériau (SGG2).

7. Détecteur à structure quantique selon l'une des revendications 1 à 6, caractérisé en ce qu'il comporte une couche de matériau semiconducteur (SG) comprise entre le substrat (S) et l'empilement de couches de matériaux semiconducteurs (SGG1)/(SPG)/(SGG2), le matériau (SG) ayant un indice de réfraction plus petit que celui du substrat (S), pour confiner l'onde optique dans l'empilement des couches.

8. Détecteur à structure quantique selon l'une des revendications 1 à 7, caractérisé en ce que l'empilement de matériaux semiconducteurs (SGG1)/(SPG)/(SGG2) est de type GaAlSb/InAsSb/GaAlSb ou de type CdTe/HgCdTe/CdTe ou de type PbS/PbS$_n$Se/Pbs.

FIG.1

FIG.2

LUMIÈRE

R

$C_1$          $C_2$

SGG2

SPG

SGG1

S

# FIG.3

Me          R

$C_1$          $C_2$

SGG2

SPG

SGG1

S

LUMIÈRE

# FIG.4

Me + C₃

R

SGG2 type p

SPG

SGG1 type n

C₄

LUMIÈRE

FIG.5

$E_{CG_1}$

$E_{CG_2}$

$E_{CP}$

$E_{VP}$

$E_{VG_1}$

$E_{VG_2}$

FIG.6

FIG.7

FIG.8

FIG.9

**Office européen des brevets**

# RAPPORT DE RECHERCHE EUROPEENNE

Numéro de la demande

EP 97 40 3090

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int.Cl.6) |
|---|---|---|---|
| A | ANDERSSON J Y ET AL: "EFFICIENCY OF GRATING COUPLED ALGAAS/GAAS QUANTUM WELL INFRARED DETECTORS" EXTENDED ABSTRACTS, vol. 93/2, 1 janvier 1993, page 215/216 XP000422280 * le document en entier * | 1-7 | H01L31/0236 H01L31/0352 |
| A | EP 0 448 869 A (AMERICAN TELEPHONE & TELEGRAPH) 2 octobre 1991 * le document en entier * | 1-7 | |
| A | US 5 378 289 A (NOGUCHI SHIGERU ET AL) 3 janvier 1995 * le document en entier * | 1 | |
| A | FR 2 729 789 A (THOMSON CSF) 26 juillet 1996 * le document en entier * | 1 | |

|   |   |
|---|---|
|   | **DOMAINES TECHNIQUES RECHERCHES (Int.Cl.6)** |
|   | H01L |

Le présent rapport a été établi pour toutes les revendications

| Lieu de la recherche | Date d'achèvement de la recherche | Examinateur |
|---|---|---|
| LA HAYE | 9 avril 1998 | Lina, F |

EPO FORM 1503 03.82 (P04C02)